# EUROPEAN PATENT APPLICATION

(11) **EP 4 628 886 A1**
(43) Date of publication of application: **08.10.2025**
(21) Application number: 23924254.8
(22) Date of filing: 25.12.2023
(51) Int. Cl.: G01N 27/72, G01R 33/12

(54) **GRAIN-ORIENTED ELECTRICAL STEEL SHEET PROCESSING STATE DETERMINING METHOD, PROCESSING STATE DETERMINING DEVICE, MANUFACTURING FACILITY ADJUSTMENT METHOD, MANUFACTURING METHOD, QUALITY CONTROL METHOD, AND MANUFACTURING FACILITY**

(30) Priority: 21.02.2023 JP 2023024932
(71) Applicant: JFE Steel Corporation, Tokyo 100-0011 (JP)
(72) Inventor: KEMMOCHI, Mitsutoshi, Tokyo 100-0011 (JP); TANI, Ryosuke, Tokyo 100-0011 (JP); KAWAHARA, Kai, Tokyo 100-0011 (JP); OTSUKA, Tatsuki, Tokyo 100-0011 (JP); OMURA, Takeshi, Tokyo 100-0011 (JP)
(74) Representative: Haseltine Lake Kempner LLP
(86) International application number: PCT/JP2023/046414
(87) International publication number: WO 2024/176610

(57) **Abstract**

A processing state determining method for a grain-oriented electrical steel sheet according to the present invention includes: a magnetization step of applying a magnetic field of a direct current or an alternating current to a region of the grain-oriented electrical steel sheet having been subjected to magnetic domain subdivision processing; a detection step of detecting a magnetic leakage flux generated in the grain-oriented electrical steel sheet as the magnetic field is applied, for each of a plurality of regions in the width direction of the grain-oriented electrical steel sheet; a calculation step of calculating a frequency distribution of each of the regions from an output signal with respect to the position in the longitudinal direction of the grain-oriented electrical steel sheet in the magnetic leakage flux of the region detected in the detection step; and a determination step of determining a state of the magnetic domain subdivision processing for each of the regions on a basis of a determination index calculated from an intensity level within a predetermined range of the frequency distribution of the region.

## Description

### Field

The present invention relates to a processing state determining method for a grain-oriented electrical steel sheet, a processing state determining apparatus, an adjustment method for manufacturing equipment, a manufacturing method, a quality control method, and manufacturing equipment.

### Background

Electromagnetic characteristics of an electrical steel sheet are one of the important characteristics that influence the product performance, and evaluation items thereof include iron loss, maximum permeability, magnetostriction, and others. The iron loss refers to a property in which, when an alternating magnetic field is applied to the electrical steel sheet, an energy loss occurs since magnetic energy is consumed as thermal energy due to magnetic hysteresis or an eddy current. Therefore, an electrical steel sheet having a small iron loss is more advantageous than an electrical steel sheet having a large iron loss since the energy conversion efficiency is higher. Regarding grain-oriented electrical steel sheets, technology for reducing iron loss has been developed, and as one type of the technology, there is a magnetic domain subdivision processing process for reducing iron loss by subdividing the width of the magnetic domain by periodically introducing local nonuniformity in the rolling direction into a surface layer by a physical method.

This magnetic domain subdivision processing process is only required to introduce non-uniformity into the surface layer and is not necessarily limited to a method in which a change in the shape such as a hole or a groove is provided in the surface layer and may be a method in which non-uniformity without a change in the shape is introduced into the surface layer. This can be implemented by, for example, a method of applying heat, pressure, or the like. More specifically, nonuniformity can be introduced into the surface layer by a method of irradiating a laser, an electron beam, a plasma jet, or the like. In a grain-oriented electrical steel sheet, there is formed a magnetic domain magnetized in a rolling direction parallel to the easy axis of magnetization. However, there is formed locally a magnetic domain magnetized in a direction different from the rolling direction in the nonuniform portion of the surface layer added by the magnetic domain subdivision processing process even if there is no damage nor change in the shape, and the discontinuity of magnetization causes magnetic domain subdivision.

As a method for evaluating a magnetic domain subdivision processing process by an electron beam, there is known a method described in Patent Literature 1. Specifically, in the method described in Patent Literature 1, a focal position shift of the electron beam is evaluated by the light emission luminance distribution of the electron beam. In addition, as a method for evaluating the processing state of the magnetic domain subdivision processing process, there are known methods described in Patent Literatures 2 and 3. In the method described in Patent Literature 2, the magnetic domain subdivision processing state is evaluated using an eddy current, and in the method described in Patent Literature 3, the magnetic domain subdivision processing state is evaluated using a magnetic leakage flux. In both methods, fast Fourier transform arithmetic processing is performed, and the magnetic domain subdivision processing state is evaluated on the basis of the intensity level of the wavelength corresponding to an interval of the magnetic domain subdivision processing.

### Citation List

### Patent Literature

Patent Literature 1: Japanese Patent No. 6398961
Patent Literature 2: Japanese Patent No. 6562055
Patent Literature 3: Japanese Patent No. 6607242

### Summary

### Technical Problem

In the method described in Patent Literature 1, it is necessary to image the irradiation position of the electron beam by an imaging apparatus; however, dirt, vapor deposition from processing, or others may adhere to a lens of the imaging apparatus, a window on an imaging path, or the like. For this reason, in order to stably evaluate the focal position deviation of the electron beam, it is necessary to frequently perform maintenance of the imaging apparatus and the like, which requires much labor. On the other hand, in the methods described in Patent Literatures 2 and 3, the intensity level of the wavelength corresponding to the interval of the magnetic domain subdivision processing and whether the magnetic domain subdivision processing state is good or poor may not necessarily be correlated due to variations in signals from other pieces of equipment in the manufacturing line, manufacturing conditions, or others. Therefore, the magnetic domain subdivision processing state may not be accurately determined. Furthermore, according to the methods described in Patent Literatures 2 and 3, it is possible to determine whether the magnetic domain subdivision processing state of the entire steel sheet is good or poor, whereas it is not possible to determine whether the magnetic domain subdivision processing state in a specific area of the steel sheet, such as only a portion of the steel sheet in the width direction, is good or poor.

The present invention has been made to solve the above disadvantages, and an object thereof is to provide a processing state determining method and a processing state determining apparatus for a grain-oriented electrical steel sheet that are capable of accurately determining the magnetic domain subdivision processing state in a specific area of the steel sheet without requiring much effort. Another object of the present invention is to provide an adjustment method and a manufacturing method of manufacturing equipment for grain-oriented electrical steel sheets capable of manufacturing grain-oriented electrical steel sheets with good yield. Another object of the present invention is to provide a quality control method for grain-oriented electrical steel sheets capable of stably providing high-quality grain-oriented electrical steel sheets. Yet another object of the present invention is to provide manufacturing equipment for grain-oriented electrical steel sheets capable of manufacturing the grain-oriented electrical steel sheets with good yield.

### Solution to Problem

To solve the problem and achieve the object, [1] a processing state determining method according to the present invention is the processing state determining method for a grain-oriented electrical steel sheet. The processing state determining method includes: a magnetization step of applying a magnetic field of a direct current or an alternating current to a region of the grain-oriented electrical steel sheet having been subjected to magnetic domain subdivision processing; a detection step of detecting a magnetic leakage flux generated in the grain-oriented electrical steel sheet as the magnetic field is applied, for each of a plurality of regions in a width direction of the grain-oriented electrical steel sheet; a calculation step of calculating a frequency distribution of each of the regions from an output signal with respect to a position in a longitudinal direction of the grain-oriented electrical steel sheet in the magnetic leakage flux of each of the regions detected in the detection step; and a determination step of determining a state of the magnetic domain subdivision processing for each of the plurality of regions on a basis of a determination index calculated from an intensity level within a predetermined range of the frequency distribution of each of the regions.

[2] Moreover, in the processing state determining method for the grain-oriented electrical steel sheet according to above [1], the predetermined range may be set on a basis of an interval of the magnetic domain subdivision processing.

[3] Moreover, in the processing state determining method for the grain-oriented electrical steel sheet according to above [1] or [2], the determination step may include a step of determining a state of the magnetic domain subdivision processing on a basis of a two-dimensional distribution of the intensity level in an in-plane direction of the grain-oriented electrical steel sheet.

[4] Moreover, a processing state determining apparatus according to the present invention is the processing state determining apparatus for a grain-oriented electrical steel sheet. The processing state determining apparatus includes: a magnetizer that applies a magnetic field of a direct current or an alternating current to a region of the grain-oriented electrical steel sheet having been subjected to magnetic domain subdivision processing; a plurality of magnetic sensors that detect a magnetic leakage flux generated in the grain-oriented electrical steel sheet as the magnetic field is applied, for each of a plurality of regions in a width direction of the grain-oriented electrical steel sheet; and a signal processing unit that calculates a frequency distribution of each of the regions from an output signal with respect to a position in a longitudinal direction of the grain-oriented electrical steel sheet in the magnetic leakage flux of each of the regions detected by the plurality of magnetic sensors, and determines a state of the magnetic domain subdivision processing for each of the plurality of regions on a basis of a determination index calculated from an intensity level within a predetermined range of the frequency distribution of each of the regions.

[5] Moreover, in the processing state determining apparatus for the grain-oriented electrical steel sheet according to above [4], the predetermined range may be set on a basis of an interval of the magnetic domain subdivision processing.

[6] Moreover, in the processing state determining apparatus for the grain-oriented electrical steel sheet according to above [4] or [5], the signal processing unit may determine a state of the magnetic domain subdivision processing on a basis of a two-dimensional distribution of the intensity level in an in-plane direction of the grain-oriented electrical steel sheet.

[7] Moreover, an adjustment method according to the present invention is the adjustment method for manufacturing equipment for a grain-oriented electrical steel sheet. The adjustment method includes a step of adjusting a state of the manufacturing equipment for a grain-oriented electrical steel sheet on a basis of the state of the magnetic domain subdivision processing of each of the plurality of regions determined using the processing state determining method for the grain-oriented electrical steel sheet according to any one of above [1] to [3].

[8] Moreover, a manufacturing method according to the present invention is the manufacturing method of a grain-oriented electrical steel sheet. The manufacturing method includes a step of controlling, on a basis of the state of the magnetic domain subdivision processing of each of the plurality of regions determined using the processing state determining method for the grain-oriented electrical steel sheet according to any one of above [1] to [3], a condition for the magnetic domain subdivision processing.

[9] Moreover, a quality control method according to the present invention is the quality control method for a grain-oriented electrical steel sheet. The quality control method includes a step of performing quality control of the grain-oriented electrical steel sheet on a basis of the state of the magnetic domain subdivision processing of each of the plurality of regions determined using the processing state determining method for the grain-oriented electrical steel sheet according to any one of above [1] to [3].

[10] Moreover, a manufacturing equipment according to the present invention is the manufacturing equipment for a grain-oriented electrical steel sheet. The manufacturing equipment includes the processing state determining apparatus for the grain-oriented electrical steel sheet according to any one of above [4] to [6]. Advantageous Effects of Invention

According to the processing state determining method and the processing state determining apparatus for grain-oriented electrical steel sheets according to the present invention, it is possible to accurately determine the magnetic domain subdivision processing state of a specific portion of a steel sheet without requiring much effort. In addition, according to the adjustment method and the manufacturing method of the manufacturing equipment for grain-oriented electrical steel sheets according to the present invention, grain-oriented electrical steel sheets can be manufactured with good yield. Furthermore, according to the quality control method for grain-oriented electrical steel sheets of the present invention, high-quality grain-oriented electrical steel sheets can be stably provided. In addition, according to the manufacturing equipment for grain-oriented electrical steel sheets of the present invention, the grain-oriented electrical steel sheets can be manufactured with good yield.

### Brief Description of Drawings

FIG. 1 is a schematic diagram illustrating the configuration of a processing state determining apparatus for a grain-oriented electrical steel sheet according to the present invention.
FIG. 2 is a diagram illustrating a two-dimensional map of magnetic leakage fluxes detected from a grain-oriented electrical steel sheet in a good magnetic domain subdivision processing state and a grain-oriented electrical steel sheet in a poor magnetic domain subdivision processing state.
FIG. 3 is a schematic diagram illustrating the configuration of a processing state determining apparatus for a grain-oriented electrical steel sheet according to an embodiment of the present invention.
FIG. 4 is a graph indicating an output signal of a magnetic sensor of a channel in an actual manufacturing line after conversion to a measured position in the longitudinal direction of a grain-oriented electrical steel sheet.
FIG. 5 includes graphs indicating results of performing FFT calculation processing on magnetic leakage flux measurement results of a grain-oriented electrical steel sheet for which magnetic domain subdivision processing is sufficient and a grain-oriented electrical steel sheet for which magnetic domain subdivision processing is insufficient, in the direction of the easy axis of magnetization.
FIG. 6 is a graph indicating the FFT intensity level of a calculation range of a determination index in the example indicated in FIG. 5.
FIG. 7 is a graph obtained by plotting correlation coefficients between a determination index and a difference between estimated and actual iron losses.
FIG. 8 is a diagram illustrating an arrangement example of processing machines and magnetic sensors.
FIG. 9 is a diagram illustrating a determination example of the magnetic domain subdivision processing state using an FFT determination index.
FIG. 10 is a diagram illustrating a determination example of the magnetic domain subdivision processing state using the FFT determination index.
FIG. 11 is a schematic diagram illustrating an example of a two-dimensional map of the FFT intensity level.
FIG. 12 is a flowchart illustrating the flow of an adjustment method of manufacturing equipment for grain-oriented electrical steel sheets according to an embodiment of the present invention.
FIG. 13 is a flowchart illustrating the flow of two-dimensional data creation processing of the FFT intensity level.

### Description of Embodiments

A processing state determining method and a processing state determining apparatus for a grain-oriented electrical steel sheet according to the present invention determine the magnetic domain subdivision processing state of a grain-oriented electrical steel sheet by nondestructively and measuring a magnetic leakage flux of the grain-oriented electrical steel sheet in a contactless manner using a magnetic leakage flux method. In the manufacturing process of the grain-oriented electrical steel sheet, the magnetic domain subdivision processing process means to locally change the magnetic properties of the grain-oriented electrical steel sheet in principle. Therefore, regarding a region having been subjected to the magnetic domain subdivision processing (hereinafter, referred to as a magnetic domain subdivision-processed portion) as a local discontinuous portion of magnetic properties, there is a magnetic flux leaking from the magnetic domain subdivision-processed portion (magnetic leakage flux). That is, the magnetic domain subdivision processing state of the grain-oriented electrical steel sheet can be determined by measuring the magnetic leakage flux by the magnetic leakage flux method.

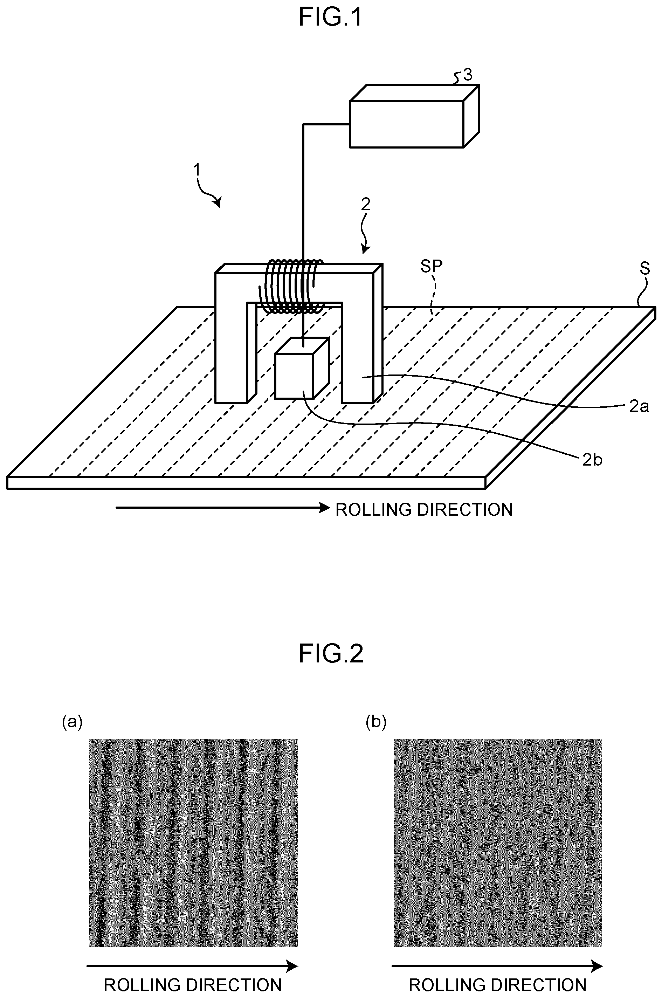

FIG. 1 is a schematic diagram illustrating the configuration of a processing state determining apparatus for a grain-oriented electrical steel sheet according to the present invention. As illustrated in FIG. 1, a processing state determining apparatus 1 for a grain-oriented electrical steel sheet according to the present invention includes a magnetic leakage flux detecting unit 2 and a signal processing unit 3 as major components. The magnetic leakage flux detecting unit 2 includes a magnetizer 2a, such as an electromagnet that magnetizes a grain-oriented electrical steel sheet S in the direction of the easy axis of magnetization, and a magnetic sensor 2b. The magnetic leakage flux detecting unit 2 is installed above the grain-oriented electrical steel sheet S in a contactless manner, applies external magnetization to the grain-oriented electrical steel sheet S passing below the magnetic leakage flux detecting unit 2, and detects a magnetic leakage flux of the grain-oriented electrical steel sheet S. Then, the signal processing unit 3 determines the magnetic domain subdivision processing state of the grain-oriented electrical steel sheet S on the basis of the magnetic leakage flux detected by the magnetic leakage flux detecting unit 2. In FIG. 1, the reference numeral SP denotes a magnetic domain subdivision-processed portion.

FIGS. 2(a) and 2(b) are each a diagram illustrating a two-dimensional map of magnetic leakage fluxes detected from a grain-oriented electrical steel sheet in a good magnetic domain subdivision processing state and a grain-oriented electrical steel sheet in a poor magnetic domain subdivision processing state. As illustrated in FIG. 2(a), in the grain-oriented electrical steel sheet having a good magnetic domain subdivision processing state, a stripe-shaped magnetic domain subdivision-processed portion can be confirmed. However, as illustrated in FIG. 2(b), in the grain-oriented electrical steel sheet in a poor magnetic domain subdivision processing state, no stripe-shaped magnetic domain subdivision-processed portion can be clearly confirmed. The iron loss value of the grain-oriented electrical steel sheet in a good magnetic domain subdivision processing state is lower than the iron loss value of the grain-oriented electrical steel sheet in a poor magnetic domain subdivision processing state. Therefore, the iron loss value of a grain-oriented electrical steel sheet can also be estimated depending on the detection situation of magnetic domain subdivision-processed portions having a stripe shape.

Generally, the magnetic domain subdivision processing is performed in a direction perpendicular to the easy axis of magnetization. When the magnetic domain subdivision processing state of a grain-oriented electrical steel sheet is determined, a magnetic field is applied in which the width of a magnetic domain whose magnetization direction is parallel to the easy axis of magnetization is smaller than the width of the magnetic domain of a magnetic domain subdivision-processed portion. In actual operation, the magnitude of the magnetic field to be applied is determined in advance by an experiment or a simulation depending on components or the thickness of the grain-oriented electrical steel sheet, and a magnetic field corresponding to components or the thickness of the grain-oriented electrical steel sheet to be determined is applied when the magnetic domain subdivision processing state is determined.

As a result of the determination, in a case where the magnetic domain subdivision processing state of the grain-oriented electrical steel sheet is not a desired state, the result is fed back to a processing machine to correct the magnetic domain subdivision processing state at an early stage. With this correction at an early stage, it is possible to avoid manufacturing a grain-oriented electrical steel sheet not satisfying the specifications and to improve the manufacturing yield of grain-oriented electrical steel sheets. Specifically, in a case where a magnetic domain subdivision-processed portion is formed using a laser or an electron beam, the magnetic domain subdivision processing state of the grain-oriented electrical steel sheet is adjusted to a desired state by adjusting output, the focus, the scanning speed, the repetition interval (line interval) of distortion in the longitudinal direction, or the like of the laser or the electron beam.

Hereinafter, the configuration and operation of the processing state determining apparatus for a grain-oriented electrical steel sheet according to an embodiment of the present invention will be described.

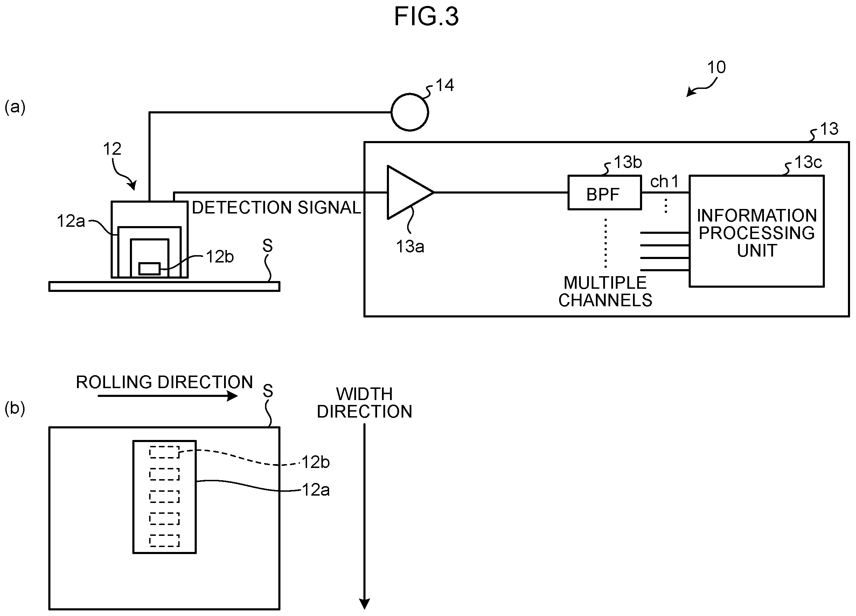

FIGS. 3(a) and 3(b) are schematic diagrams illustrating the configuration of the processing state determining apparatus for a grain-oriented electrical steel sheet according to an embodiment of the present invention. As illustrated in FIGS. 3(a) and 3(b), a processing state determining apparatus 10 for a grain-oriented electrical steel sheet according to an embodiment of the present invention includes a magnetic leakage flux detecting unit 12, a signal processing unit 13, and an excitation power supply 14 as main components. In the present embodiment, the signal processing unit 13 and the excitation power supply 14 are configured separately; however, the signal processing unit 13 and the excitation power supply 14 may be integrally configured. In FIGS. 3(a) and 3(b), the longitudinal direction of the grain-oriented electrical steel sheet S is the same as the rolling direction in FIG. 3(b). Meanwhile, the width direction of the grain-oriented electrical steel sheet S in FIGS. 3(a) and 3(b) is a direction orthogonal to the rolling direction in FIG. 3(b) in the drawing.

The magnetic leakage flux detecting unit 12 includes a magnetizer 12a and a plurality of magnetic sensors 12b and is disposed to face the top surface of the grain-oriented electrical steel sheet S.

The magnetizer 12a applies external magnetization to the grain-oriented electrical steel sheet S using excitation power (excitation frequency in the case of AC) supplied from the excitation power supply 14. In the present embodiment, a magnetic domain wall of a magnetic domain in a region not having been subjected to the magnetic domain subdivision processing moves, and the size of external magnetization whose magnetization direction of a magnetic domain in a region subjected to the magnetic domain subdivision processing is not parallel to the easy axis of magnetization is set within a range of 0 to 100 AT(100 AT: magnitude of the external magnetization obtained by applying a current of 0.1 A to a 1000 winding coil). In this case, the magnetic flux density of the grain-oriented electrical steel sheet S was 0 to 1.7 mT. The magnetizer 12a may be an electromagnet or a permanent magnet. Considering the thickness of the grain-oriented electrical steel sheet S, fine adjustment of lift-off, and others, an electromagnet might be easier to adjust. However, even in a case where a permanent magnet is used, the present invention can be applied by having a structure in which the relative position between the magnetic sensor 12b and the permanent magnet can be separately adjusted.

The plurality of magnetic sensors 12b is arrayed in the width direction of the grain-oriented electrical steel sheet S. The magnetic sensor 12b detects the magnetic leakage flux of the grain-oriented electrical steel sheet S generated as the external magnetization is applied, for each of a plurality of regions (channels) in the width direction of the grain-oriented electrical steel sheet S. In the case where the external magnetization applied to the grain-oriented electrical steel sheet S is AC, a magnetic leakage flux of the grain-oriented electrical steel sheet S is detected by performing detection depending on the excitation frequency. At that point, it is desirable to further adjust the phase of a detection signal. In the present embodiment, a magnetic sensor 12b includes a tunnel effect (TMR) sensor and detects a magnetic leakage flux component parallel to the surface of the grain-oriented electrical steel sheet S. As the magnetic sensor 12b, a highly sensitive sensor is desirably used, and a SQUID, an MI (magnetic impedance type), a Hall element, a GMR (magnetic resistance type), an E-type sensor in which a coil is wound around an E-type ferromagnetic core, or the like can be used.

The signal processing unit 13 includes an amplifier 13a, a plurality of bandpass filters (BPFs) 13b, and an information processing unit 13c. The amplifier 13a amplifies output signals of the plurality of magnetic sensors 12b and outputs the amplified output signals to corresponding BPFs 13b. The plurality of BPFs 13b extracts an output signal of a set frequency band from the output signal of the amplifier 13a and outputs the extracted output signal to the information processing unit 13c. The information processing unit 13c determines the processing state of a magnetic domain subdivision-processed portion of the grain-oriented electrical steel sheet S for each of the plurality of regions (channels) using the output signals of the plurality of BPFs 13b.

In a case where a magnetic flux distribution is generated in the thickness direction of the grain-oriented electrical steel sheet using the skin effect, an AC magnetic leakage flux method using an AC current is also applicable. However, in this case, an AC processing circuit is separately required. As the AC processing circuit, it suffices to use an absolute value circuit and a low-pass filter as long as only the amplitude value of an output signal is evaluated. In a case where the amplitude value and the phase of an output signal are evaluated, it is necessary to perform detection at the excitation frequency, and thus a detection circuit is required.

When the measurement is performed by the magnetic sensors 12b, the grain-oriented electrical steel sheet S is relatively moved by a predetermined length in the direction of the easy axis of magnetization. This can be achieved by, for example, moving the grain-oriented electrical steel sheet S by a predetermined length by a conveying apparatus or the like, moving the magnetizer 12a and the magnetic sensors 12b by a predetermined length on the grain-oriented electrical steel sheet S by a movement apparatus or the like, or combining movement of the grain-oriented electrical steel sheet S and the magnetic sensors 12b. In the present invention, the easy axis of magnetization of the grain-oriented electrical steel sheet S is the longitudinal direction and the rolling direction of the grain-oriented electrical steel sheet S. In the case of the present embodiment, the magnetic sensors 12b and the magnetizer 12a are fixed, and the grain-oriented electrical steel sheet S is conveyed by a predetermined length in the longitudinal direction (rolling direction in FIG. 3(b)).

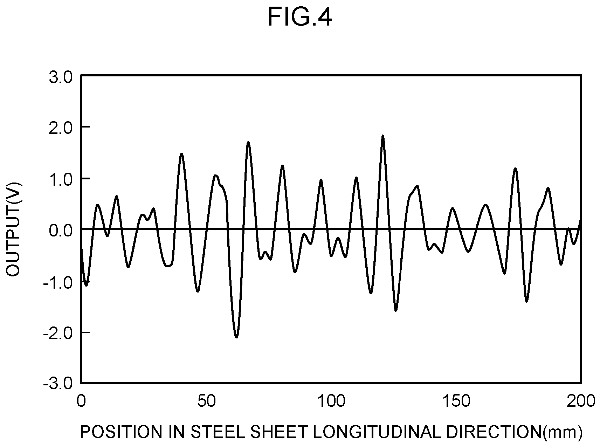

FIG. 4 is a graph indicating an output signal of a magnetic sensor 12b of a certain channel in an actual manufacturing line after conversion to a measured position (unit: mm) in the longitudinal direction of the grain-oriented electrical steel sheet S. In the example illustrated in FIG. 4, the detection pitch of the magnetic sensor 12b was set to 0.1268 mm/point, and magnetic domain subdivision-processed portions at intervals of 8.0 mm were detected as changes in the output signal. In the present embodiment, frequency analysis is employed as an example of a determination index of such an output signal. At this point, it is preferable to adjust the predetermined length in the longitudinal direction so as to obtain the number of signals for which frequency analysis can be appropriately performed. In the case of FIG. 4, the relative movement distance of the magnetic sensor 12b in the longitudinal direction of the grain-oriented electrical steel sheet S was set to 200 mm under the above detection pitch conditions.

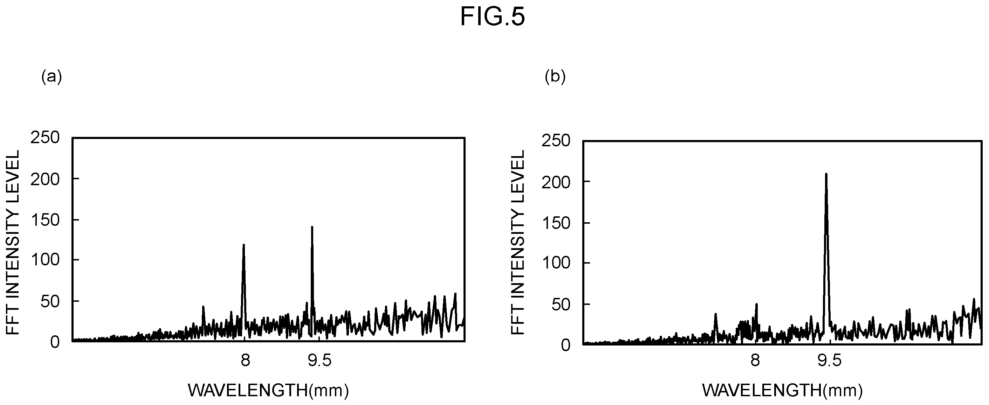

FIGS. 5(a) and 5(b) are graphs indicating results of performing FFT calculation processing, in the direction of the easy axis of magnetization, on magnetic leakage flux measurement results of a grain-oriented electrical steel sheet for which the magnetic domain subdivision processing is sufficient and a grain-oriented electrical steel sheet for which the magnetic domain subdivision processing is insufficient. The vertical axis represents a value representing the complex number of an FFT calculation processing result as an absolute value (hereinafter, referred to as FFT intensity level), and the horizontal axis represents a value obtained by converting the frequency obtained as a result of the FFT calculation processing into a wavelength. As illustrated in FIG. 5(b), in the grain-oriented electrical steel sheet in which the magnetic domain subdivision processing is insufficient, the FFT intensity level around a wavelength of 8.0 mm is small. On the other hand, as illustrated in FIG. 5(a), in the grain-oriented electrical steel sheet in which the magnetic domain subdivision processing is sufficient, the FFT intensity level around the wavelength of 8.0 mm is large. In addition, in this example, in both of the grain-oriented electrical steel sheets for which the magnetic domain subdivision processing is sufficient and insufficient, the FFT intensity level is high around a wavelength of 9.4 mm due to a noise signal considered to be from another facility in the manufacturing line. In this manner, the FFT intensity level also changes depending on the noise signal and a processing interval of the magnetic domain subdivision processing. Therefore, as in the method described in Patent Literature 3, in a case where the intensity level of a specific wavelength is used as a determination index for the magnetic domain subdivision processing, there is a possibility that the magnetic domain subdivision processing state cannot be accurately determined.

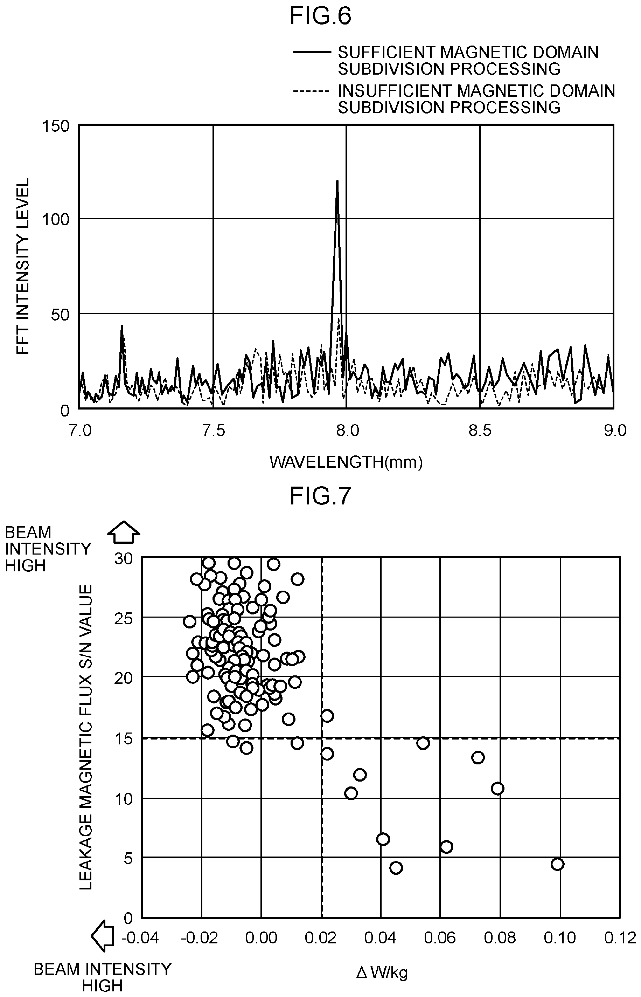

Therefore, in the present embodiment, the information processing unit 13c calculates a more accurate determination index as follows. First, a calculation range of the determination index in the wavelength (frequency) direction is set in advance depending on the interval of the magnetic domain subdivision-processed portion. For example, in a case where the magnetic domain subdivision-processed portions are at the interval of 8.0 mm, and the noise signal is around the wavelength of 9.4 mm as in the example illustrated in FIGS. 5(a) and 5(b), the calculation range of the determination index is set to a range of wavelengths of 7.0 to 9.0 mm or the like. The calculation range of the determination index is desirably set such that the interval between the magnetic domain subdivision-processed portions is always within the range and that the peak value of the noise signal due to variations in other facilities or manufacturing conditions is not within the range. In FIG. 6, illustrated is the FFT intensity level of the calculation range of the determination index in the example illustrated in FIGS. 5(a) and 5(b).

Next, the information processing unit 13c calculates a signal value (S) and a noise value (N) from the FFT intensity levels in the set calculation range. The signal value (S) may be the maximum value of the FFT intensity levels in the calculation range or may be the sum of three points including the FFT intensity level of a wavelength corresponding to the interval of magnetic domain subdivision-processed portions and preceding and following points thereof or the like. Furthermore, the noise value (N) may be an average value of the FFT intensity levels in the calculation range or may be a predetermined fixed value. In addition, the calculation ranges of the signal value (S) and the noise value (N) may be set separately in different ranges. Lastly, the information processing unit 13c calculates a ratio (S/N) between the signal value (S) and the noise value (N) as the determination index. In this manner, the influence of the peak value of the FFT intensity level due to the noise signal which is known can be eliminated, and the influence of a change in the FFT signal level due to a steady change in the noise signal can also be reduced.

It has been confirmed that this determination index has a high correlation with a difference between estimated and actual iron losses in the actual manufacturing line. FIG. 7 is a graph obtained by plotting correlation coefficients between the determination index (magnetic leakage flux S/N value) and a difference ΔW between estimated and actual iron losses. In the example illustrated in FIG. 7, the interval between the magnetic domain subdivision-processed portions was 8.0 mm, and the calculation range of the determination index was set to a range of wavelengths of 7.0 to 9.0 mm. In addition, the signal value (S) was set to the maximum value of the FFT intensity levels in the calculation range, and the noise value (N) was set to the average value of the FFT intensity levels in the calculation range. As illustrated in FIG. 7, it can be seen that there is a good correlation between the determination index and the difference ΔW between estimated and actual iron losses. Therefore, by using this determination index, it is possible to accurately determine whether the magnetic domain subdivision processing state is good or poor.

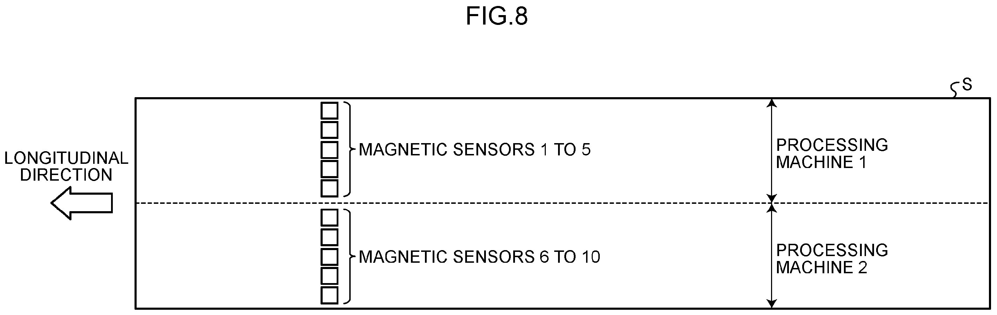

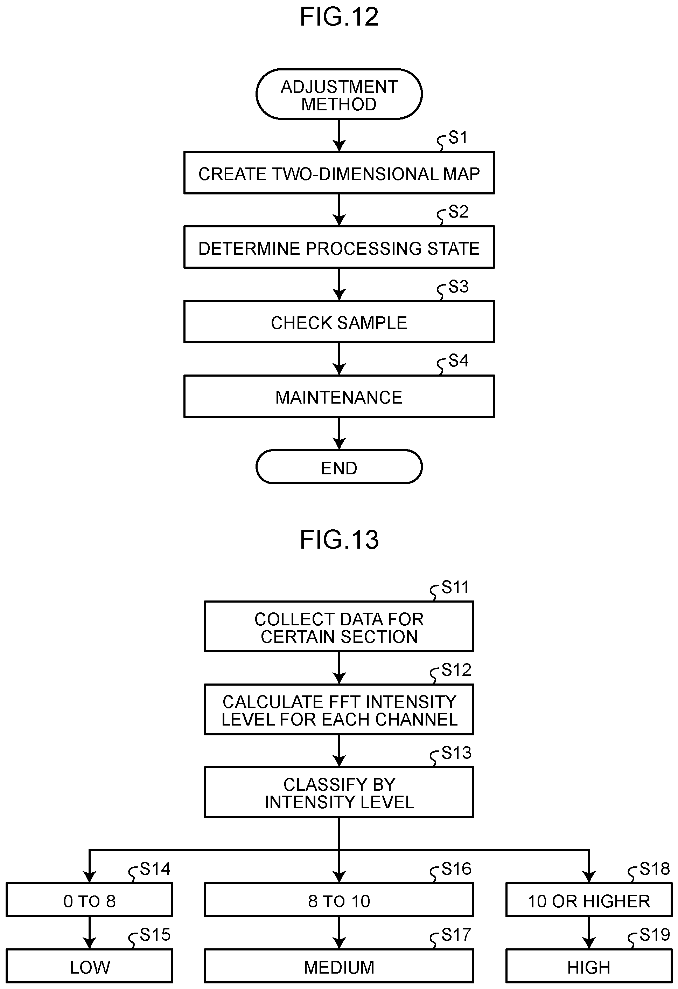

In addition, it is desirable to create two-dimensional data of the FFT intensity level in the width direction and the longitudinal direction of the steel sheet and to determine the magnetic domain subdivision processing state on the basis of two-dimensional data of the FFT intensity levels. Specifically, for example, as illustrated in FIG. 8, in a case where two processing machines are arranged in parallel in the width direction and magnetic domain subdivision processing is performed over the entire width of the grain-oriented electrical steel sheet, magnetic sensors of first to fifth channels correspond to a first processing machine 1, and magnetic sensors of sixth to tenth channels correspond to a second processing machine 2. Illustrated in FIG. 13 is an example of the flow of two-dimensional data creation processing. In this example, there is measurement data for ten channels in the width direction. First, in the processing of step S11, output signals of magnetic leakage fluxes (for example, 32768 points that are powers of 2) are collected for each constant length in the longitudinal direction. Next, in the processing of step S12, the frequency distribution is calculated by performing the fast Fourier transform operation processing for each of the channels to calculate the FFT intensity level for each of the channels. At this point, the calculation is performed for each of the channels, output signals of each of the channels are not added in the processing of step S11, and FFT calculation processing results are not added unlike in the method described in Patent Literature 2 in the processing of step S12. Next, in the processing of step S13, the ratio (S/N) between the signal value (S) and the noise value (N) is calculated as the determination index from the calculated FFT intensity level, and the channels are classified on the basis of the calculated determination index. Then, for a channel whose determination index is within a range of 0 to 8 (step S14), the FFT intensity level in a corresponding two-dimensional data region is set to "low" (step S15). Meanwhile, for a channel whose determination index is within a range of 8 to 10 (step S16), the FFT intensity level in a corresponding two-dimensional data region is set to "medium" (step S17). For a channel whose determination index is larger than 10 (step S18), the FFT intensity level in a corresponding two-dimensional data region is set to "high" (step S19). By repeating this, such two-dimensional data of FFT intensity levels as ten channels in the width direction x several tens of points in the longitudinal direction can be created for a coil, which is one manufacturing unit.

Those conceivable as the cause of an unstable magnetic domain subdivision processing state include inappropriate adjustment of output of a laser beam or an electron beam of a processing machine, the focus, a scanning speed, a repetition interval (line interval) of distortion in the longitudinal direction, and the like due to wear of a roller or the like. Another conceivable cause is fluttering of the grain-oriented electrical steel sheet when the conveyance speed of the grain-oriented electrical steel sheet at the time of processing changes. In addition, an unstable magnetic domain subdivision processing state occurs continuously in each processing machine and in the longitudinal direction. For example, in a case where adjustment of the focus of a processing machine is shifted, the FFT intensity level decreases continuously in the longitudinal direction in a plurality of channels corresponding to the specific processing machine. In addition, even in a case where the fluttering of the steel sheet when the conveyance speed changes is the cause, the intensity level decreases continuously in the longitudinal direction in a plurality of channels corresponding to a specific processing machine or a plurality of processing machines.

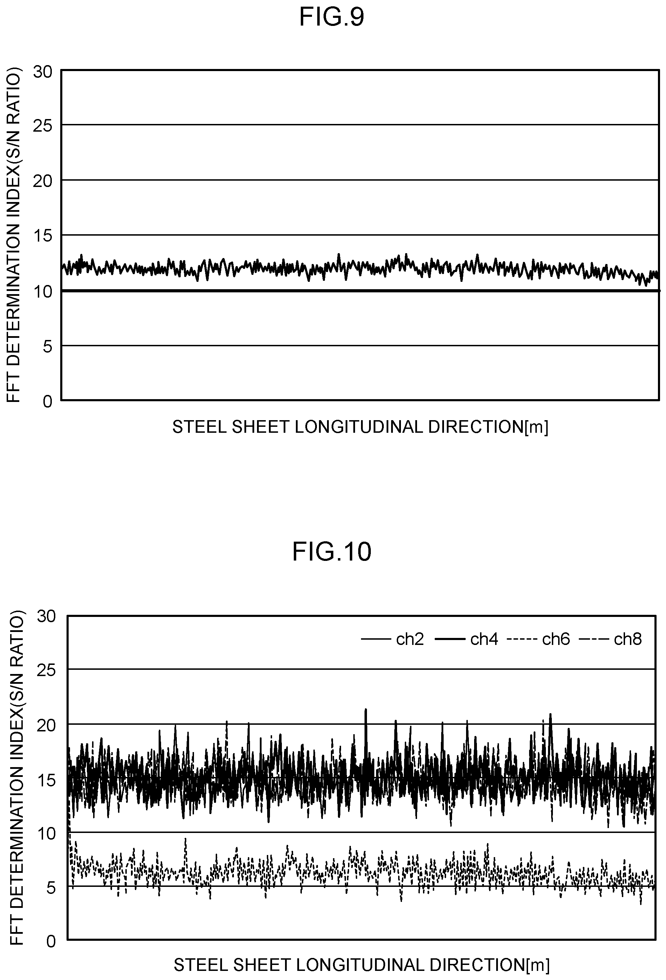

Therefore, with an index of the measurement range based on one frequency distribution, it is difficult to accurately determine whether the magnetic domain subdivision processing state is good or poor due to noise or variations. However, by using the two-dimensional data as described above, it is possible to accurately determine whether the magnetic domain subdivision processing state is good or poor. An example of determination using data obtained in an actual manufacturing line is shown. As described above, it is based on the premise that magnetic sensors of ten channels are arranged in the width direction and that a steel sheet passes through nine channels of the second to tenth channels. For example, as in the method described in Patent Literature 2, an example of a case where the magnetic domain subdivision processing state is determined using, as the determination index, the sum of FFT calculation processing results of the nine channels is illustrated in FIG. 9. Presuming that the FFT determination index having a threshold of greater than or equal to 10 is determined to be good and the FFT determination index having a threshold of less than 10 is determined to be poor, in this case, the magnetic domain subdivision processing state is determined to be good. Meanwhile, FIG. 10 illustrates an excerpt of determination indexes of two channels, four channels, six channels, and eight channels obtained from the same data. By individually determining each of the channels in the width direction, it is possible to determine that the magnetic domain subdivision processing state is poor in a portion corresponding to the six channels. Actually, in the steel sheet of this data, the state of the magnetic domain subdivision processing was not favorable and the iron loss was poor in the corresponding width direction.

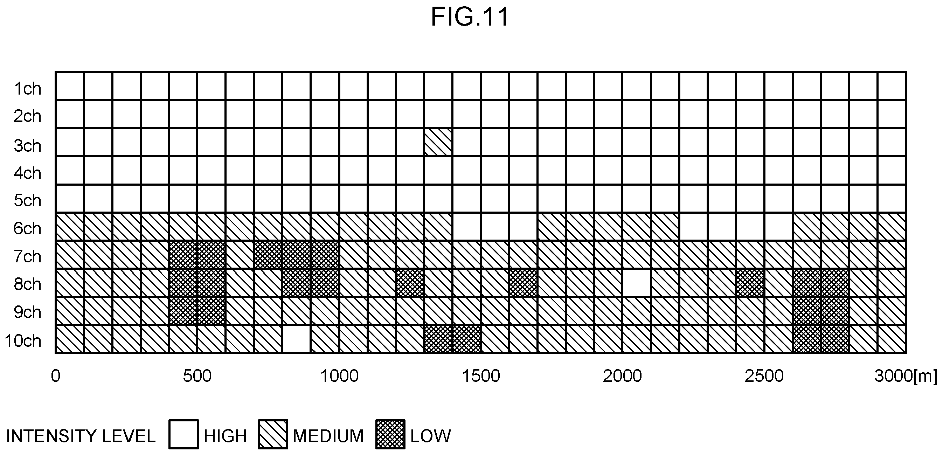

In determination using such two-dimensional data, a two-dimensional map of the FFT intensity level may be created for each coil as a manufacturing unit by displaying one intensity level calculated value in color or the like. For example, displaying the FFT intensity level in red, yellow, green, or the like as illustrated in FIG. 11 makes it possible to easily visually determine a state in which the FFT intensity level at the normal time is stably high, a state in which there is only one part where the FFT intensity level is low, and a state in which the FFT intensity level at a part corresponding to a specific processing machine at an abnormal time is continuously low. The threshold of the FFT intensity level calculated value can be determined separately for each channel or each manufacturing condition. In addition, automatic determination may be created such as that an abnormality is determined when adjacent channels of the two-dimensional data continuously fall below a threshold a certain number of times or more. As described above, by acquiring the determination index calculated from the FFT calculation processing results as two-dimensional data, it is made possible to accurately determine the situation of the magnetic domain subdivision processing.

The closer the magnetic sensors are to the grain-oriented electrical steel sheet, the higher the detection accuracy of the magnetic leakage fluxes. However, the distance (lift-off amount) between the magnetic sensors and the grain-oriented electrical steel sheet is actually about 0.3 to 3 mm since fluttering of the grain-oriented electrical steel sheet causes contact and others. In a case where the detection signal varies due to fluctuations of the lift-off amount, it is necessary to correct the lift-off amount. It is also important to provide a distance meter (laser or eddy current type) for measuring the distance between the magnetic sensors and the electrical steel sheet for maintaining the detection accuracy of the magnetic leakage fluxes. In a case where fluttering of the grain-oriented electrical steel sheet is substantial, a conveyance roller may be newly installed, a magnetizer may be disposed adjacent to an existing roller, or a magnetizer may be disposed in an existing roller. In addition, since the magnetization level applied to the grain-oriented electrical steel sheet is small, an air-core coil may be used as the magnetizer.

As is apparent from the above description, in the processing state determining method for a grain-oriented electrical steel sheet according to the embodiment of the present invention, a magnetic field of a direct current or an alternating current is applied to a region of the grain-oriented electrical steel sheet having been subjected to the magnetic domain subdivision processing, a magnetic leakage flux, which is generated in the grain-oriented electrical steel sheet as the magnetic field is applied, is detected for each of the plurality of regions in the width direction of the grain-oriented electrical steel sheet, a frequency distribution of each of the regions is calculated from an output signal with respect to the position in the longitudinal direction of the grain-oriented electrical steel sheet in the magnetic leakage flux of the region detected in the detection step, and the magnetic domain subdivision processing state is determined for each of the regions on the basis of an intensity level within a predetermined range of the frequency distribution of the region. Therefore, the magnetic domain subdivision processing state of a specific portion of the steel sheet can be accurately determined without requiring much effort.

In addition, the manufacturing yield of grain-oriented electrical steel sheets can be improved by adjusting the state of the manufacturing equipment for grain-oriented electrical steel sheets on the basis of the magnetic domain subdivision processing state for each region determined using the processing state determining method for a grain-oriented electrical steel sheet according to the embodiment of the present invention. Specifically, as illustrated in FIG. 12, a two-dimensional map of FFT intensity levels is created (step S1), and the magnetic domain subdivision processing state is determined on the basis of the two-dimensional map (step S2). Then, the position where the magnetic domain subdivision processing state is determined to be poor is confirmed on a sample (step S3), and the state of the manufacturing equipment such as an electron gun is adjusted on the basis of the confirmation result (step S4). As a result, the production yield of the grain-oriented electrical steel sheets can be improved. Furthermore, for the same reason as described above, the production yield of the grain-oriented electrical steel sheets can be improved by the manufacturing equipment for grain-oriented electrical steel sheets including the processing state determining apparatus for grain-oriented electrical steel sheets according to the embodiment of the present invention.

In addition, the manufacturing yield of grain-oriented electrical steel sheets can be improved by controlling the condition for the magnetic domain subdivision on the basis of the magnetic domain subdivision processing state for each region determined using the processing state determining method for a grain-oriented electrical steel sheet according to the embodiment of the present invention. Specifically, by feeding back the determination result of the magnetic domain subdivision processing state to the processing machine and correcting the magnetic domain subdivision processing state at an early stage, it is possible to avoid manufacturing a grain-oriented electrical steel sheet deviating from the specifications and to improve the manufacturing yield of grain-oriented electrical steel sheets.

In addition, it is possible to stably provide a high-quality grain-oriented electrical steel sheet by performing quality control of the grain-oriented electrical steel sheet on the basis of the state of the magnetic domain subdivision processing for each region determined using the processing state determining method for a grain-oriented electrical steel sheet according to an embodiment of the present invention. Specifically, by classifying the grain-oriented electrical steel sheets by quality depending on the determination result of the magnetic domain subdivision processing state, it is possible to stably provide high-quality grain-oriented electrical steel sheets.

Although the embodiments applied with the invention made by the present inventors have been described above, the present invention is not limited by the description and the drawings included as a part of the disclosure of the present invention according to the embodiments. That is, other embodiments, examples, operation technology, and the like implemented by those skilled in the art on the basis of the present embodiments are all included in the scope of the invention.

### Industrial Applicability

According to the present invention, it is possible to provide a processing state determining method and a processing state determining apparatus for a grain-oriented electrical steel sheet that are capable of accurately determining a magnetic domain subdivision processing state in a specific area of the steel sheet without requiring much effort. Furthermore, according to the present invention, it is possible to provide an adjustment method and a manufacturing method of manufacturing equipment for grain-oriented electrical steel sheets that are capable of manufacturing grain-oriented electrical steel sheets with high yield. According to the present invention, it is also possible to provide a quality control method for grain-oriented electrical steel sheets that is capable of stably providing high-quality grain-oriented electrical steel sheets. In addition, according to the present invention, it is possible to provide the manufacturing equipment for grain-oriented electrical steel sheets capable of manufacturing the grain-oriented electrical steel sheets with good yield.

### Reference Signs List

1, 10 PROCESSING STATE DETERMINING APPARATUS FOR GRAIN-ORIENTED ELECTRICAL STEEL SHEET
2, 12 MAGNETIC LEAKAGE FLUX DETECTING UNIT
2a, 12a MAGNETIZER
2b, 12b MAGNETIC SENSOR
3, 13 SIGNAL PROCESSING UNIT
13a AMPLIFIER
13b BANDPASS FILTER (BPF)
13c INFORMATION PROCESSING UNIT
14 EXCITATION POWER SUPPLY
S GRAIN-ORIENTED ELECTRICAL STEEL SHEET
SP MAGNETIC DOMAIN SUBDIVISION-PROCESSED PORTION

## Claims

1. A processing state determining method for a grain-oriented electrical steel sheet, the processing state determining method comprising:
a magnetization step of applying a magnetic field of a direct current or an alternating current to a region of the grain-oriented electrical steel sheet having been subjected to magnetic domain subdivision processing;
a detection step of detecting a magnetic leakage flux generated in the grain-oriented electrical steel sheet as the magnetic field is applied, for each of a plurality of regions in a width direction of the grain-oriented electrical steel sheet;
a calculation step of calculating a frequency distribution of each of the regions from an output signal with respect to a position in a longitudinal direction of the grain-oriented electrical steel sheet in the magnetic leakage flux of each of the regions detected in the detection step; and
a determination step of determining a state of the magnetic domain subdivision processing for each of the plurality of regions on a basis of a determination index calculated from an intensity level within a predetermined range of the frequency distribution of each of the regions.

2. The processing state determining method for the grain-oriented electrical steel sheet according to claim 1, wherein the predetermined range is set on a basis of an interval of the magnetic domain subdivision processing.

3. The processing state determining method for the grain-oriented electrical steel sheet according to claim 1 or 2, wherein the determination step includes a step of determining a state of the magnetic domain subdivision processing on a basis of a two-dimensional distribution of the intensity level in an in-plane direction of the grain-oriented electrical steel sheet.

4. A processing state determining apparatus for a grain-oriented electrical steel sheet, the processing state determining apparatus comprising:
a magnetizer that applies a magnetic field of a direct current or an alternating current to a region of the grain-oriented electrical steel sheet having been subjected to magnetic domain subdivision processing;
a plurality of magnetic sensors that detect a magnetic leakage flux generated in the grain-oriented electrical steel sheet as the magnetic field is applied, for each of a plurality of regions in a width direction of the grain-oriented electrical steel sheet; and
a signal processing unit that calculates a frequency distribution of each of the regions from an output signal with respect to a position in a longitudinal direction of the grain-oriented electrical steel sheet in the magnetic leakage flux of each of the regions detected by the plurality of magnetic sensors, and determines a state of the magnetic domain subdivision processing for each of the plurality of regions on a basis of a determination index calculated from an intensity level within a predetermined range of the frequency distribution of each of the regions.

5. The processing state determining apparatus for the grain-oriented electrical steel sheet according to claim 4, wherein the predetermined range is set on a basis of an interval of the magnetic domain subdivision processing.

6. The processing state determining apparatus for the grain-oriented electrical steel sheet according to claim 4 or 5, wherein the signal processing unit determines a state of the magnetic domain subdivision processing on a basis of a two-dimensional distribution of the intensity level in an in-plane direction of the grain-oriented electrical steel sheet.

7. An adjustment method for manufacturing equipment for a grain-oriented electrical steel sheet, the adjustment method comprising a step of adjusting a state of the manufacturing equipment for a grain-oriented electrical steel sheet on a basis of the state of the magnetic domain subdivision processing of each of the plurality of regions determined using the processing state determining method for the grain-oriented electrical steel sheet according to any one of claims 1 to 3.

8. A manufacturing method of a grain-oriented electrical steel sheet, the manufacturing method comprising a step of controlling, on a basis of the state of the magnetic domain subdivision processing of each of the plurality of regions determined using the processing state determining method for the grain-oriented electrical steel sheet according to any one of claims 1 to 3, a condition for the magnetic domain subdivision processing.

9. A quality control method for a grain-oriented electrical steel sheet, the quality control method comprising a step of performing quality control of the grain-oriented electrical steel sheet on a basis of the state of the magnetic domain subdivision processing of each of the plurality of regions determined using the processing state determining method for the grain-oriented electrical steel sheet according to any one of claims 1 to 3.

10. Manufacturing equipment for a grain-oriented electrical steel sheet, the manufacturing equipment comprising the processing state determining apparatus for the grain-oriented electrical steel sheet according to any one of claims 4 to 6.
